# EUROPÄISCHE PATENTSCHRIFT

(11) **EP 3 370 491 B1**
(45) Veröffentlichungstag und Bekanntmachung des Hinweises auf die Patenterteilung: **18.11.2020**
(21) Anmeldenummer: 18158426.9
(22) Anmeldetag: 23.02.2018
(51) Int. Cl.: H05K 7/20

(54) **ANORDNUNG EINES KÜHLSYSTEMS ZUR KÜHLUNG MINDESTENS EINES, IN EINEM RAUM ANGEORDNETEN SERVERSCHRANKS**
ASSEMBLY OF A COOLING SYSTEM FOR COOLING AT LEAST ONE SERVER RACK IN A ROOM
SYSTÈME DE REFROIDISSEMENT DESTINÉ AU REFROIDISSEMENT D'UNE ARMOIRE DE SERVEUR DISPOSÉE DANS UN ESPACE

(30) Priorität: 03.03.2017 DE 102017104538
(43) Veröffentlichungstag der Anmeldung: 05.09.2018
(73) Patentinhaber: Apelsin Enterprises GmbH, 64342 Seeheim-Jugenheim (DE)
(72) Erfinder: Tennigkeit, Jörg, 64342 Seeheim-Jugenheim (DE)
(74) Vertreter: Freischem & Partner Patentanwälte mbB

(56) Entgegenhaltungen:
- EP-A1- 3 113 592
- US-A1- 2012 063 087
- US-B1- 7 800 900
- US-B1- 9 426 903

## Beschreibung

Die Erfindung betrifft eine Anordnung eines Kühlsystems zur Kühlung mindestens eines, in einem Raum angeordneten Serverschranks. Insbesondere betrifft die Erfindung die Anordnung eines Kühlsystems zur Kühlung von mehreren Serverschränken, die in einem Raum zur Datenverarbeitung in einer oder mehreren Reihen derart aufgestellt sind, dass vor und hinter jeder Reihe von Serverschränken entsprechende Gänge in Form von mindestens einem Kaltgang und mindestens einem Warmgang gebildet sind. In einen Kaltgang wird kalte Luft eingebracht. Von einem Kaltgang wird die kalte Luft zur Kühlung der in den Serverschränken angeordneten Servern und/oder etwaigen sonstigen - üblicherweise elektronischen - IT-Geräten durch die Serverschränke hindurch in einen Warmgang geleitet. Ein Kaltgang befindet sich dabei häufig auf der Vorderseite der Serverschränke und ist damit ein Gang im engeren Sinne, der auch von einer Person durchlaufen werden kann. Ein Warmgang befindet sich üblicherweise auf der gegenüberliegenden Rückseite der Serverschränke (und ist dann ebenfalls ein Gang im engeren Sinne). Alternativ oder in Ergänzung kann ein Warmgang auch oberhalb der Serverschränke angeordnet sein und/oder nur in Form eines Abluftkanals vorliegen.

Aus EP 3 113 592 A1 ist ein Schrankklimatisierungsführungsmechanismus bekannt, wobei an einem Schrank zur Anordnung von Servern ein vorderer Rahmen und ein hinterer Rahmen angeordnet sind. Der vordere Rahmen dient zur Zuleitung von Luft in den Schrank und der hintere Rahmen zur Ableitung von aus dem Schrank austretender Luft. Es ist ferner ein Kühlungsmechanismus vorgesehen, welcher einen Zuluftkanal, einen Abluftkanal und eine Kühlvorrichtung umfasst, wobei der Kühlvorrichtung heiße Luft zugeführt wird und die Kühlvorrichtung kühle Luft erzeugt. Die Kühlvorrichtung ist über den Zuluftkanal mit dem vorderen Rahmen verbunden und der hintere Rahmen ist mit dem Abluftkanal verbunden, so dass eine Klimatisierung des Schranks unter Einsatz der Kühlvorrichtung erfolgt.

Bei der im Folgenden noch im Detail beschriebenen erfindungsgemäßen Anordnung handelt es sich bei einem Warmgang und einem Kaltgang vorzugsweise um Gänge im engeren Sinne, die sich vor, hinter oder neben Serverschränken erstrecken und von einer Person begangen werden können.
Mit dem Begriff "Raum" sind vorliegend von der Atmosphäre separierte Räume gemeint, wie beispielsweise ein Raum innerhalb eines Gebäudes oder ein Container bzw. ein Raum eines Containers.

Aus der Praxis sind sogenannte In-Row-Kühlanordnungen bekannt, bei welchen innerhalb von Serverschrankreihen zwischen zwei Serverschränken Kühlvorrichtungen positioniert werden. Solche In-Row-Kühlanordnungen haben den Nachteil, dass diese Nutzraum für Serverschränke beanspruchen. Alternativ oder in Ergänzung können Kühlvorrichtungen auch am Ende einer Serverschrankreihe oder eines Kaltgangs angeordnet sein und Luft entweder direkt in den Kaltgang eines Raumes oder über einen zusätzlichen Kanal in den Kaltgang einblasen. Auch bei dieser Anordnung beanspruchen die Kühlanordnungen Nutzraum innerhalb der Serverschrankreihe oder im Kaltgang.

Aus der Praxis sind auch Kühlanordnungen mit sogenannten Doppelböden bekannt. Bei diesen Kühlanordnungen wird kalte Luft durch einen unterhalb des begehbaren Bodens eingezogenen Kühlkanal geführt und in einen Kaltgang eingebracht. Diese Kühlanordnungen beanspruchen zwar keine Serverschrank-Stellfläche und somit keinen Nutzraum, haben aber den Nachteil, dass sie aufwendig und teuer in der Errichtung sind. Denn sie müssen für die meist ein hohes Gewicht aufweisenden Vorrichtungen von Rechenzentren ausgelegt und dimensioniert sein. Ferner sind zusätzliche Überwachungs- und Löschmaßnahmen betreffend den Brandschutz erforderlich.

Der Erfindung liegt die Aufgabe zugrunde, eine Anordnung eines Kühlsystems zur Kühlung mindestens eines in einem Raum angeordneten Serverschranks zur Verfügung zu stellen, die keine zusätzliche Serverschrank-Stellfläche beansprucht, kostengünstig errichtet und effizient betrieben werden kann.

Gemäß einer erfindungsgemäßen Anordnung eines Kühlsystems zur Kühlung mindestens eines, in einem Raum angeordneten Serverschranks ist zumindest ein auf einer ersten Seite des Serverschranks angeordneter Kaltgang vorgesehen und ein auf einer zweiten Seite des Serverschranks angeordneter Warmgang vorgesehen. Bei der ersten Seite und der zweiten Seite kann es sich insbesondere um die Vorderseite(n) und die Rückseite(n) eines Serverschranks oder mehrere Serverschränke handeln.

Dabei ist zur Kühlung des mindestens einen Serverschranks deckenseitig des Raums mindestens ein, den Kaltgang mit Kühlluft versorgender Zuluftkanal mit mindestens einer von dem Zuluftkanal in den Kaltgang führenden Einströmöffnung vorgesehen. Im Warmgang ist deckenseitig des Raums ein Luft aus dem Warmgang fördernder Abluftkanal mit mindestens einer von dem Warmgang in den Abluftkanal führenden Abluftöffnung vorgesehen. Darüber hinaus ist der Zuluftkanal mit einer Zuluftleitung für eine direkte freie Kühlung verbunden, und in dem Zuluftkanal, in dem Abluftkanal oder in mindestens einem von dem Abluftkanal zum Zuluftkanal führenden Verbindungskanal ist mindestens eine Kühlvorrichtung angeordnet. Bei dem Serverschrank handelt es sich insbesondere um einen Schrank, der zur Installation von IT-, EDV-, Netzwerk- und/oder Telekommunikationssystemen vorgesehen ist.

Solche Serverschränke können insbesondere einen Korpus umfassen, der Mittel zur Aufnahme einer Haltevorrichtung oder eine Haltevorrichtung zur Aufnahme von und Verbindung mit IT-, EDV-, Netzwerk- und/oder Telekommunikationssystemen in genormten Standardgrößen umfasst. Derartige Mittel können beispielsweise geschlitzte oder gelochte Stahlbleche sein, welche das Einstecken, Einschrauben oder sonstige Verbindungen von bekannten Haltevorrichtungen für Serverschränke ermöglicht. Zum Anmeldezeitpunkt waren Standardformate für die oben genannten Systeme insbesondere 19 Zoll und 21 Zoll. Andere Formate, die aufgrund variierender Gehäusegrößen aktuell werden, sind von der vorliegenden Offenbarung jedoch mit umfasst. Bei Haltevorrichtungen in Verbindung mit Serverschränken im Sinne der Erfindung bezieht sich das vorstehend erwähnte Format von 19 Zoll bzw. 21 Zoll insbesondere auf die Breite der entsprechenden Haltevorrichtung, welche den Einbau beliebiger Geräte des entsprechenden Formats ermöglicht. Die Tiefe des (jeweiligen) Serverschranks kann variieren. Häufige Bautiefen sind 60 cm, 80 cm, 100 cm und 120 cm. Vorzugsweise weisen alle Serverschränke in einer Reihe die gleiche Bautiefe auf, damit sich durch Vorder- und Rückseite von in einer Reihe angeordneten Serverschränken jeweils eine glattflächige Begrenzungswand für den Warmgang bzw. Kaltgang ergibt. Die Erfindung ist nicht auf die vorstehend genannten Bautiefen beschränkt.

Unter einer Kühlvorrichtung im Sinne der Erfindung ist jede Vorrichtung zu verstehen, welche dazu ausgebildet ist, durch diese hindurchströmende Luft abzukühlen. Die Verwendung einer Kühlvorrichtung, bei der es sich beispielsweise um ein Klimatisierungsgerät, ein mechanisches Kälteerzeugungsgerät oder einen Wärmetauscher handeln kann, hat - insbesondere wenn die Kühlvorrichtung im Zuluftkanal angeordnet ist - den Vorteil, dass diese auch für die zusätzliche Kühlung durch ungekühlte Umgebungsluft geeignet ist, bevor die Luft in den Kaltgang einströmt. Darüber hinaus ist eine solche Kühlvorrichtung auch dazu geeignet, Luft aus dem Warmgang oder dem Abluftkanal, die zurück in den Zuluftkanal gefördert wird, erneut zu kühlen und anschließend erneut dem Kaltgang zuzuführen (Umluftbetrieb).

Gemäß einer erfindungsgemäßen Anordnung ist sowohl mindestens ein Zuluftkanal als auch mindestens ein Abluftkanal deckenseitig eines Raumes installiert. Damit ist gemeint, dass die Luft jeweils von der Oberseite her in den Kaltgang eingebracht wird bzw. in Richtung Oberseite aus dem Warmgang abgeführt wird. Die in dem Zuluftkanal, in dem Abluftkanal oder in mindestens einem von dem Abluftkanal zum Zuluftkanal führenden Verbindungskanal angeordnete Kühlvorrichtung ist ebenfalls deckenseitig angeordnet. Dies hat im Vergleich zu den eingangs geschilderten, aus dem Stand der Technik bekannten Anordnungen mehrere Vorteile. Zum einen wird keine Serverschrank-Stellfläche für die Anordnung von Kühlvorrichtungen benötigt. Ferner sind auch keine speziellen, bodenseitigen Baumaßnahmen erforderlich, die zusätzliche Kosten verursachen würden. Darüber hinaus kann mit der erfindungsgemäßen Anordnung von dem physikalischen Prinzip profitiert werden, dass im Vergleich zur Umgebung kältere Luft sich schwerkraftbedingt nach unten in Richtung Boden bewegt. Die deckenseitige Anordnung des Zuluftkanals hat insoweit den Vorteil, dass das Ausströmen der Kühlluft schwerkraftbedingt unterstützt wird.

Die Luft wird anschließend durch die Serverschränke hindurch zu einer zweiten Seite des Serverschranks in den Warmgang geleitet, insbesondere zu einer Rückseite des Serverschranks. Im Warmgang kann bei der erfindungsgemäßen Anordnung wiederum von dem physikalischen Prinzip profitiert werden, so dass im Vergleich zur Umgebung wärmere Luft aufsteigt. Die Luft im Warmgang bewegt sich damit auch ohne zusätzliche Lüfter nach oben in Richtung der Abluftöffnungen.

Schließlich wird noch darauf verwiesen, dass die erfindungsgemäße Anordnung gegenüber bekannten Lösungen den Vorteil hat, dass zwei unabhängige Kühlsysteme in einem Bereich eines Raumes angeordnet sind, der üblicherweise nicht für andere Elemente oder Funktionen genutzt wird. Darüber hinaus ergeben sich die vorstehend erläuterten physikalischen Wirkvorteile.

Zu den beiden unabhängig voneinander vorhandenen Kühlmöglichkeiten wird noch darauf verwiesen, dass unter einer direkten freien Kühlung im Sinne der Erfindung insbesondere die Verwendung von ungekühlter Umgebungsluft verstanden wird. Unter ungekühlter Umgebungsluft wird insbesondere atmosphärische Außenluft verstanden, welche über einen Zuluftkanal von einer Außenwand eines Gebäudes, eines Containers oder eines sonstigen Bauwerks zu dem darin angeordneten Raum der Anordnung, insbesondere in den Kaltgang, eingeleitet wird. Umgebungsluft im Sinne der Erfindung kann jedoch auch Luft aus einem von dem Raum beabstandeten Raum sein, welcher beispielsweise aufgrund seiner Lage (z.B. Keller) oder aufgrund bereits vorhandener technischer Einrichtungen (z.B. ein vollklimatisierter oder gekühlter Raum, in welchem sich die Serverschränke nicht befinden) eine ausreichende Luftmenge zur Verfügung stellen kann, welche über den Zuluftkanal ohne weitere Kühlung in den Kaltgang eingeleitet werden kann. Wichtig ist, dass die Luft über einen Zuluftkanal zu dem Serverschrank geleitet wird, welcher einen gewissen Abstand zwischen dem Serverschrank und der Umgebung überbrückt, aus der die Luft angesaugt wird. Vorzugsweise weist der Zuluftkanal eine Isolierung auf. Mit dem Wort "ungekühlt" im Sinne der Erfindung ist gemeint, dass Luft aus einer von dem Serverschrank beabstandeten Umgebung angesaugt und ohne zusätzliche Kühlung über einen Zuluftkanal zu dem Raum geleitet wird.

Als Kühlsysteme im Sinne der Erfindung werden jegliche Vorrichtungen verstanden, die dazu geeignet sind, Luft mittelbar oder unmittelbar zu kühlen. Dies sind insbesondere Wärmetauscher, wie beispielsweise Luft-Wasser-Wärmetauscher, Kühlgeräte mit Kompressor(en) und Verdampfer(n) oder auch Reservoirs, denen große Mengen Kühlenergie oder Kühlmittel entnehmbar sind. Die Nutzung eines Kältereservoirs kann beispielsweise in einer Industrieanlage in Betracht kommen, in welcher prozessbedingt große Kältemengen für den kontinuierlichen Betrieb eines Wärmetauschers zur Verfügung stehen. Ein solches Kältereservoir kann aber auch ein Fluss, ein See oder ein großer Gebäudekeller sein.

Erfindungsgemäß sind mehrere Serverschränke in einer Reihe angeordnet und mehrere Kühlvorrichtungen in mehreren, jeweils von dem Abluftkanal zu dem Zuluftkanal führenden Verbindungskanälen angeordnet, wobei die Kühlvorrichtungen ebenfalls in einer Reihe unmittelbar über den Serverschränken angeordnet sind. So kann auch bei längeren Reihen mit einer Vielzahl von Serverschränken mit kompakten Kühlvorrichtungen eine effiziente und bauraumoptimierte Kühlung der Serverschränke erfolgen. Insbesondere ergibt sich in diesem Fall - in einer Ansicht von oben - eine leiterartige Struktur mit einem sich parallel zum Kaltgang erstreckenden Zuluftkanal, einem parallel zu dem Zuluftkanal verlaufenden, über dem Warmgang angeordneten Abluftkanal und sich sprossenartig zwischen dem Abluftkanal und dem Zuluftkanal erstreckenden Verbindungskanälen.

Der Vollständigkeit halber wird darauf hingewiesen, dass anstelle einer Vielzahl von Sprossen (d.h. zwei oder mehr Sprossen) auch nur ein großflächiger Verbindungskanal zwischen dem Abluftkanal und dem Zuluftkanal vorgesehen sein kann.

Das Vorsehen von vielen einzelnen Verbindungskanälen hat demgegenüber jedoch den Vorteil, dass Luftführungs- und Steuerungsmaßnahmen bereichsweise vorgenommen werden können, um den Kühlbedarf über die Länge von Warm- und Kaltgang verschiedenen Geräten und/oder Serverschränken anpassen zu können. So kann beispielsweise in Abschnitten mit hohem Kühlbedarf ein höherer Volumenstrom von Zuluftkanal zum Abluftkanal geleitet werden als in Abschnitten mit geringerem Kühlbedarf, insbesondere indem die Durchströmquerschnitte der Einströmöffnungen und/oder der Abluftöffnungen in ihrer Größe an den Bedarf angepasst sind.

In einer praktischen Ausführungsform sind für die direkte freie Kühlung mindestens eine Zuluftleitung und mindestens eine Abluftleitung vorgesehen, wobei in der Zuluftleitung eine Zuluft-Brandschutzklappe und in der Abluftleitung eine Abluft-Brandschutzklappe vorgesehen sind, um die Zuluftleitung und die Abluftleitung bedarfsweise vollständig verschließen zu können. Diese Ausführungsform ist insbesondere in Verbindung mit solchen Kühlvorrichtungen von Vorteil, die in einem Umluftbetrieb ohne benötigte Luftwege zur Atmosphäre betrieben werden können. Dies sind insbesondere Kühlvorrichtungen in Form von Split-Geräten mit mindestens einem in dem Raum angeordneten Verdampfer und mindestens einem außenseitig eines Gebäudes, Containers oder sonstigen Bauwerks angeordneten Kompressor. Ebenso zählen so solchen Kühlvorrichtungen Luft-Wasser-Wärmetauscher, bei denen die Luft im Umluftbetrieb verwendet werden kann, sowie Kühlvorrichtungen, die mit innerhalb des Gebäudes, Containers oder sonstigen Bauwerks angeordneten Kältereservoirs zusammenwirken.

Ein wichtiger Vorteil in Verbindung mit einer solchen Anordnung mit Brandschutzklappen ist, dass die Kühlung der Serverschränke auch dann weiterhin sichergestellt ist, wenn es aufgrund eines Gebäudebrandes oder aufgrund sonstiger Situationen, welche eine Betätigung der Brandschutzklappen erfordern oder diese empfehlen, dazu kommt, dass die Brandschutzklappen geschlossen werden.

In einer weiteren praktischen Ausführungsform einer erfindungsgemäßen Anordnung sind in dem Zuluftkanal mehrere Einströmöffnungen angeordnet, wobei mindestens eine Einströmöffnung eine Luftmengensteuervorrichtung aufweist. Vorzugsweise weist jede Einströmöffnung eine Luftmengensteuervorrichtung auf. Mit einer Luftmengensteuervorrichtung sind insbesondere Vorrichtungen gemeint, die es ermöglichen, den Durchströmquerschnitt der Einströmöffnung zu variieren, um bedarfsweise den Luftstrom durch eine Einströmöffnung zu erhöhen oder zu reduzieren. Diesbezüglich wird insbesondere auf in ihrem Winkel einstellbare Lamellen verwiesen. Insbesondere können Luftmengensteuervorrichtungen mit in eine vollständig geschlossene Position mit einer Lamellenorientierung senkrecht zur Durchströmrichtung und eine vollständig geöffneten Position mit einer Lamellenorientierung parallel zur Durchströmrichtung eingesetzt werden.

Der Einsatz von Luftmengensteuervorrichtungen kann beispielsweise dann von Vorteil sein, wenn die Wärmeentwicklung und die damit korrespondierende erforderliche Kühlleistung in einzelnen Serverschränken unterschiedlich hoch sind bzw. variieren. In diesem Fall kann durch eine geeignete Steuerung bzw. Einstellung der Luftmengensteuervorrichtung jeder Serverschrank bzw. verschiedene Serverschrankgruppen optimiert werden, indem die Durchströmquerschnitte relativ zu den Kühlbedarfen angepasst werden. Die Anpassung bzw. Einstellung kann dabei manuell, halbautomatisch oder vollautomatisch erfolgen.

In diesem Zusammenhang wird insbesondere darauf verwiesen, dass durch eine Anpassung der Durchströmquerschnitte auch dem Effekt Rechnung getragen werden kann, dass der Luftdruck hinter einem Luftfördermittel mit zunehmendem Abstand zu dem Luftfördermittel abnimmt. Wenn trotzdem ein gleichmäßiger Luftstrom durch eine Mehrzahl von Einströmöffnungen gefördert werden soll, kann diese mit Hilfe der Luftmengensteuervorrichtungen dadurch erreicht werden, dass die Durchströmquerschnitte mit zunehmendem Abstand zu dem Luftfördermittel so viel größer eingestellt werden, dass sich ein jeweils gleich großer Luftstrom durch die jeweiligen Einströmöffnungen ergibt.

Das Vorstehende gilt analog auch für eine weitere praktische Ausführungsform einer erfindungsgemäßen Anordnung, bei welcher in dem Abluftkanal mehrere Abluftöffnungen angeordnet sind und mindestens eine Abluftöffnung eine Luftmengensteuervorrichtung aufweist. Auch in dieser Ausführungsform ist es bevorzugt, wenn jede Abluftöffnung eine Luftmengensteuervorrichtung aufweist. Durch die Kombination von Luftmengensteuervorrichtungen im Bereich der Abluftöffnungen und der Einströmöffnungen können auch weitere Effekte erzielt werden, beispielsweise Längsströmungen, um innerhalb des Kaltgangs und/oder innerhalb des Warmgangs parallel zur Richtung der Serverschrankreihen strömende Luft zu erzeugen. Dies kann insbesondere dadurch bewirkt werden, dass eine mit einer Einströmöffnung korrespondierende Abluftöffnung nicht auf einer Verbindungslinie senkrecht zur Serverschrankreihe angeordnet bzw. geöffnet ist, sondern nur mit einem Versatz in Längsrichtung, so dass sich die Luft zwangsläufig auch in Längsrichtung bewegen muss, um zu der nächstliegenden (und somit korrespondierenden) Abluftöffnung zu gelangen.

Viele in Serverschränken installierte elektronische Geräte benötigen Luft, die bestimmten Anforderungen bezüglich der Temperatur und/oder der Luftfeuchtigkeit genügt. Dies können insbesondere die Einhaltung einer Maximaltemperatur (z.B. 35°C, 40°C oder 45°C) sein, die Einhaltung einer Mindesttemperatur (z.B. mindestens 5°C oder 10°C) und/oder die Einhaltung von Werten für die Luftfeuchtigkeit (z.B. zwischen 30% und 55% relative Luftfeuchtigkeit).

Um derartige Anforderungen zuverlässig erfüllen zu können, kann es vorteilhaft sein, wenn bei einer erfindungsgemäßen Anordnung der Abluftkanal über einen Bypasskanal mit dem Zuluftkanal verbunden ist und mindestens eine Mischkammer vorgesehen ist, um einen Frischluftstrom und einen Abluftstrom für die Einströmung in den Zuluftkanal zusammenzuführen - und optional auch konditionieren - zu können.

Bezüglich der Zusammenführung und Konditionierung von Abluft und Frischluft in der Mischkammer wird insbesondere darauf verwiesen, dass Klappen vorgesehen sein können, um das Einströmen und Frischluft und/oder Abluft in die Mischkammer bzw. in den Zuluftkanal stufenlos steuern zu können.

Vorzugsweise wird eine erfindungsgemäße Anordnung ausschließlich über die direkte freie Kühlung betrieben, solange die über die Zuluftleitung zuströmende Luft eine Temperatur innerhalb eines Soll-Temperaturbereichs aufweist und somit entweder ungemischt unmittelbar in den Kaltgang eingebracht werden kann oder durch Zumischen von Abluft in einen geeigneten Temperaturbereich (und ggf. auch Luftfeuchtigkeitszustand) gebracht werden kann.

In diesem Zusammenhang wird noch auf eine optionale Möglichkeit zum Steuern bzw. Betreiben einer erfindungsgemäßen Anordnung in einer besonders energieeffizienten Art und Weise verwiesen. Für die meisten Serverschränke gibt es Vorgaben, wie groß der Temperaturunterschied zwischen dem Warmgang und dem Kaltgang maximal sein darf, beispielsweise 10°K oder 15°K. Eine ordnungsgemäße Kühlung von Serverschränken kann insbesondere mit Hilfe der Luftmenge und des Temperaturunterschiedes zwischen Kaltgang und Warmgang variiert werden. Das bedeutet, einem erhöhten Kühlbedarf kann entweder dadurch Rechnung getragen werden, dass die geförderte Luftmenge pro Zeit erhöht wird und/oder dadurch, dass die Temperaturdifferenz zwischen Warmgang und Kaltgang (innerhalb zulässiger Grenzen) durch Reduzierung der Temperatur im Kaltgang erhöht wird.

In einer besonders energieeffizienten Ausführungsform einer erfindungsgemäßen Anordnung ist sowohl im Warmgang als auch im Kaltgang jeweils mindestens ein Temperatursensor angeordnet und überwacht kontiniuerlich, die vorherrschenden Temperaturen. Sobald eine Änderung des Kühlbedarfs festgestellt wird, wird von einer Energiesteuerung überprüft, welches - unter Berücksichtigung aktuell vorherrschender weiterer Parameter (z.B. der Temperatur der atmosphärischen Außenluft für die direkte freie Kühlung im Bereich einer Zuluft-Mischklappe) die kostengünstigste Variante zur Anpassung an den Kühlbedarf ist. Basierend auf diesem Ergebnis wird dann die Luftmenge pro Zeit und/oder das Verhältnis von Außenluft zu Abluft angepasst, sofern eine Kühlung ausschließlich über die direkte freie Kühlung erfolgen kann. Sobald die Kühlvorrichtung aktiviert werden muss, wird mit Hilfe der Energiesteuerung zusätzlich überwacht, welche Kombination aus Kühlvorrichtung, direkter freier Kühlung und Luftfördermittel die kostengünstigste bedarfsgerechte Kühlung der Serverschränke ermöglicht. Auf ein entsprechendes Betriebsverfahren einer erfindungsgemäßen Anordnung zum energieeffizienten Betreiben eines erfindungsgemäßen Systems wird an dieser Stelle explizit verwiesen.

In einer weiteren praktischen Ausführungsform einer erfindungsgemäßen Anordnung ist mindestens eine Rückschlagarmatur derart in dem Abluftkanal, in dem Verbindungskanal, in dem Bypasskanal und/oder in dem Zuluftkanal angeordnet, dass einer Luftströmung von dem Zuluftkanal durch den Verbindungskanal oder dem Bypasskanal in den Abluftkanal mittels der Rückschlagarmatur gegengewirkt wird. Bei einer derartigen Rückschlagarmatur kann es sich insbesondere um eine Rückschlagklappe handeln, die in eine Richtung aufschwenkbar ist und in die andere Richtung einen Fluidstrom sperrt. Als Rückschlagarmatur ebenfalls geeignet sind Rückschlagventile oder sonstige Bauformen von Rückschlagarmaturen.

Wenn mindestens eine Steuervorrichtung vorgesehen ist, um den Durchströmquerschnitt mindestens einer Auslassöffnung und/oder die Steuerung mindestens einer Mischklappe einer Mischkammer abhängig von mit Hilfe von Sensoren ermittelten Steuerparametern und/oder Regelparametern einzustellen, können einzelne Luftströmungen, insbesondere in Querrichtung von dem Zuluftkanal in den Kaltgang durch die Serverschränke und den Warmgang zu dem Abluftkanal strömende Luftströmungen, bedarfsgerecht und auch dynamisch dimensioniert werden.

Die Durchströmquerschnitte der Auslassöffnungen (und ggf. auch der Einströmöffnungen oder mindestens einer Einströmöffnung) können insbesondere mit Hilfe von entsprechenden Luftmengensteuervorrichtungen erfolgen. Diesbezüglich wird erneut insbesondere auf in ihrem Winkel einstellbare Lamellen verwiesen, die - über die Steuerung angetrieben - in eine vollständig geschlossene Position mit einer Lamellenorientierung senkrecht zur Durchströmrichtung und eine vollständig geöffneten Position mit einer Lamellenorientierung parallel zur Durchströmrichtung gebracht werden kann.

In einer weiteren praktischen Ausführungsform einer erfindungsgemäßen Anordnung ist mindestens eine erste Überwachungsvorrichtung für die direkte freie Kühlung und eine zweite Überwachungsvorrichtung für die Kühlvorrichtung vorgesehen, mittels welchen unabhängig voneinander die Temperatur im Zuluftkanal überwacht wird. Dies hat den Vorteil, dass zwei voneinander unabhängige Überwachungsvorrichtungen vorgesehen sind, um bedarfsweise die Kühlvorrichtung zu aktivieren. Durch derartige Überwachungsvorrichtungen kann die Sicherheit einer erfindungsgemäßen Anordnung erhöht werden, insbesondere wenn jede Überwachungsvorrichtung mit einer Aktivierungsvorrichtung gekoppelt ist, die eine Aktivierung der Kühlvorrichtung ermöglicht.

Die Sicherheit einer erfindungsgemäßen Anordnung kann weiter erhöht werden, wenn eine Master-Überwachungsvorrichtung mit einem Bimetall-Schalter vorgesehen ist, die funktional derart mit der mindestens einen Kühlvorrichtung gekoppelt ist, dass bei Erreichen oder Überschreiten einer Maximaltemperatur die mindestens eine Kühlvorrichtung aktiviert wird. Eine derartige Master-Überwachungsvorrichtung hat den weiteren Vorteil, dass diese unabhängig von der Funktionsfähigkeit eines elektronischen Schalters rein temperaturgesteuert ausgeführt ist.

Um trotz der deckenseitigen Installation von Kühlvorrichtungen, insbesondere wenn solche Kühlvorrichtungen zumindest in bestimmten Betriebszuständen potentiell Kondensat produzieren, weiter zu erhöhen, ist in einer weiteren praktischen Ausführungsform die mindestens eine Kühlvorrichtung von einer ersten Kondensatwanne und von einer zweiten Kondensatwanne derart umgeben, dass schwerkraftbedingt abtropfendes oder ablaufendes Kondensat zunächst von der ersten Kondensatwanne aufgefangen und in einen Ablaufkanal geführt wird und im Falle einer Fehlfunktion des ersten Ablaufkanals Kondensat von der ersten Kondensatwanne in die zweite Kondensatwanne überläuft und von dieser in einen Ablaufkanal geführt wird. Durch ein derartiges doppeltes Wannensystem kann sichergestellt werden, dass im Falle einer erhöhten Kondensatproduktion und/oder eines verstopften Ablaufkanals keine Flüssigkeit von oben in Richtung der Serverschränke gelangen kann.

Die Sicherheit kann weiter erhöht werden, indem mindestens ein Sensor in der ersten Kondensatwanne und/oder in der zweiten Kondensatwanne installiert wird, um im Falle einer Störung einer Warnmeldung akustischer, haptischer und/oder sonstiger Art und Weise (z.B. per E-Mail, SMS etc.) ausgeben zu können. Insbesondere ist dann sichergestellt, dass zu dem Zeitpunkt der Aussendung einer Warnmeldung noch immer ein vollständig funktionierendes System vorliegt, so dass eine Schädigung der Inhalte des Serverschranks nahezu auszuschließen ist.

Weitere praktische Ausführungsformen und Vorteile der Erfindung sind nachfolgend im Zusammenhang mit den Zeichnungen beschrieben. Es zeigen:
- Fig. 1: eine schematische Darstellung von drei Serverschrankreihen mit einem dazwischen gebildeten Kaltgang und einem Warmgang in einer Ansicht von oben,
- Fig. 2: die Serverschrankreihen aus Fig. 1 mit einer erfindungsgemäßen Anordnung in einer Ansicht von vorne gemäß dem Pfeil II in Fig. 1,
- Fig. 3: nur die mittlere Serverschrankreihe aus Fig. 1 mit einer schematischen Darstellung einer erfindungsgemäßen Anordnung eines Kühlsystems in einer Ansicht von oben,
- Fig. 4: die Anordnung aus Fig. 3 mit Darstellung der Luftführung in einer ersten Betriebsart,
- Fig. 5: die Anordnung aus Fig. 3 mit Darstellung der Luftführung in einer zweiten Betriebsart und
- Fig. 6: eine schematische Darstellung einer Kühlvorrichtung einer erfindungsgemäßen Anordnung mit einer ersten Kondensatwanne und einer zweiten Kondensatwanne in einer Seitenansicht.

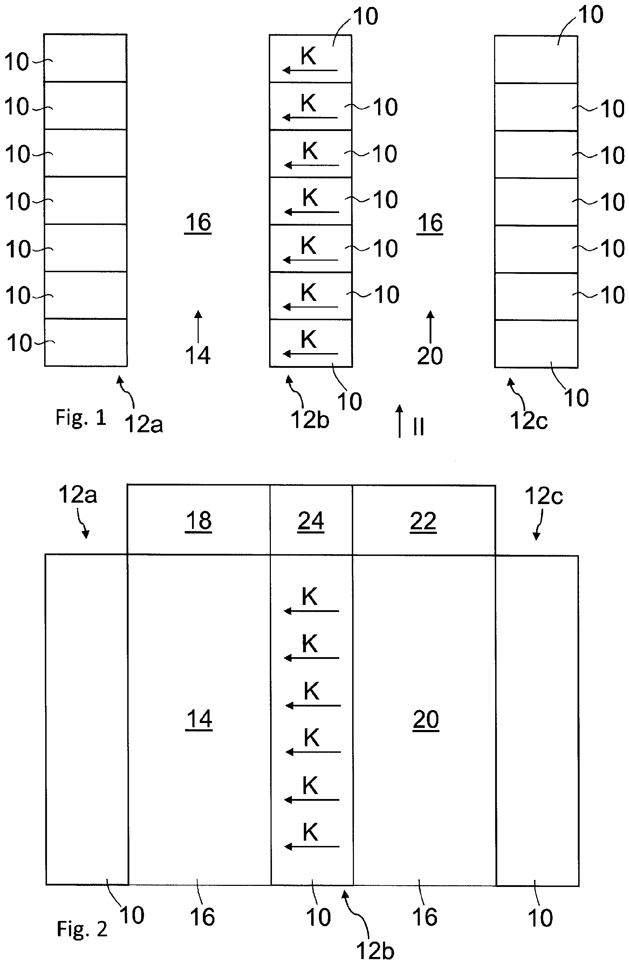

Figur 1 zeigt eine Vielzahl von Serverschränken 10 in einer schematischen Darstellung von oben. Die Serverschränke 10 sind in drei Reihen 12a, 12b, 12c in einem Raum (hier: Serverraum) eines Gebäudes angeordnet, wobei die Wände des Serverraums und des Gebäudes in den Figuren nicht dargestellt sind. Figur 2 zeigt die Reihen 12a, 12b, 12c mit den Serverschränken 10 in einer Ansicht von vorne gemäß dem Pfeil II in Figur 1.

Wie in Figur 2 erkennbar ist, ist in dem gezeigten Ausführungsbeispiel zwischen den Reihen 12a und 12 b ein sogenannter Warmgang 14 gebildet, welcher sich vom Boden 16, auf welchem die Serverschränke 10 aufgestellt sind, bis zu einem deckenseitig installierten Abluftkanal 18 erstreckt.

Analog dazu ist zwischen den Reihen 12b und 12c mit Serverschränken 10 ein Kaltgang 20 gebildet, welcher sich vom Boden 16 bis zu einem Zuluftkanal 22 erstreckt.

In Figur 2 ist auch erkennbar, dass ein Bypasskanal 24 im vorderen Bereich über der Reihe 12b verläuft, welcher den Abluftkanal 18 mit dem Zuluftkanal 22 verbindet.

Der Vollständigkeit halber wird darauf hingewiesen, dass in Figur 1 der Bereich oberhalb der Serverschränke 10 mit dem Zuluftkanal 22, dem Abluftkanal 18 und dem Bypasskanal 24 sowie weiteren deckenseitig installierten Elementen nicht dargestellt ist. In Figur 1 ist daher der Blick von oben durch den Warmgang 14 bzw. Kaltgang 20 unmittelbar auf den Boden 16 frei.

Ebenfalls wird darauf hingewiesen, dass es nicht zwingend erforderlich ist, dass die Unterseiten des Abluftkanals 18 und des Zuluftkanals 22 - wie in Fig. 2 dargestellt - bündig mit den Oberseiten der Serverschränke 10 abschließen. Es ist auch möglich, den Zuluftkanal 22 und den Abluftkanal 18 anders anzuordnen, insbesondere höher. In diesem Fall ist es bevorzugt, als Luftführungselemente Gangschottungselemente einzusetzen, um zu vermeiden, dass Luft über die Serverschränke 10 hinweg in einen anderen Gang strömen kann. Vorteilhaft an der dargestellten bündigen Anordnung ist, dass keine zusätzlichen Luftführungselemente (Gangschottungselemente) seitlich oberhalb der Serverschränke 10 benötigt werden.

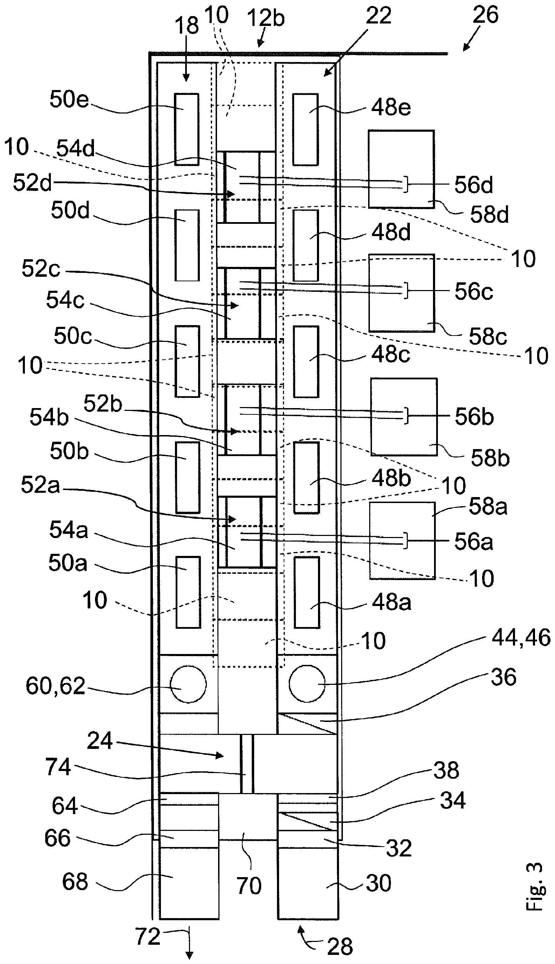

Eine vollständige erfindungsgemäße Anordnung 26 nur in Verbindung mit der mittleren Reihe 12b aus den Fig. 1 und 2 in einer schematischen Ansicht von oben ist in Figur 3 dargestellt. In dieser Darstellung sind die Serverschränke 10 der mittleren Reihe 12b teilweise von dem Zuluftkanal 22, teilweise von dem Abluftkanal 18 und dazwischen von weiteren, im Folgenden noch erläuterten Elementen verdeckt. Aus diesem Grund sind die Serverschränke 10 nur als nicht sichtbare Elemente gestrichelt dargestellt.

In der Ansicht von Figur 3 sind die einströmseitig des Zuluftkanals 22, abströmseitig des Abluftkanals 18 und die zwischen dem Zuluftkanal 22 und dem Abluftkanal 18 installierten Elemente im Detail dargestellt. Diese Elemente werden im Folgenden im Detail erläutert.

Atmosphärische Außenluft aus dem Bereich außerhalb des nicht dargestellten Gebäudes, in welchem sich der Raum mit den Serverschränken 10 befindet, kann über eine nur schematisch dargestellte Zuluftleitung 28 durch einen optionalen Zuluft-Schalldämpfer 30 zu einer ebenfalls optionalen Zuluft-Brandschutzklappe 32 gelangen.

Stromabwärts der Zuluft-Brandschutzklappe 32 ist ein Grobfilter 34 angeordnet. Aus dem Grobfilter 34 ausströmende Luft gelangt zu einer Zuluft-Mischklappe 38. Die Zuluft-Mischklappe 38 ermöglicht es, die Menge an Frischluft, welche über die Zuluftleitung 28 in den Zuluftkanal 22 strömen soll, zu steuern, indem die Zuluft-Mischklappe 38 vollständig geöffnet, vollständig geschlossen oder teilweise geschlossen wird.

Stromabwärts der Zuluft-Mischklappe 38 mündet der Bypasskanal 24, über welchen Abluft aus dem Abluftkanal 18 bedarfsweise zurück in den Zuluftkanal 22 geführt werden kann. Stromabwärts der Mündungsstelle des Bypasskanals 24 ist ein Feinfilter 36 angeordnet, um über den Bypasskanal 24 in den Zuluftkanal 22 gelangende Luft wiederum filtern zu können.

Der Vollständigkeit halber wird darauf verwiesen, dass der Feinfilter 36 alternativ auch unmittelbar hinter dem Grobfilter 34 angeordnet sein kann, so dass beide Filter 34, 36 vor der Zuluft-Mischklappe 38 angeordnet sind (nicht dargestellte Variante).

Ebenso ist es möglich, den Grobfilter 34 unmittelbar vor dem Feinfilter 36 anzuordnen, so dass beide Filter 34, 36 hinter der Zuluft-Mischklappe 38 angeordnet sind (nicht dargestellte Variante).

Bei einer Installation der Anordnugn in einem Raum ohne Brandschutzwertigkeit können die Brandschutzklappen entfallen.

Als Luftfördermittel 44 ist in dem Zuluftkanal 22 ein Zuluftventilator 46 angeordnet. Stromabwärts des Zuluftventilators 46 erstreckt sich der Zuluftkanal 22 parallel und entlang der Reihe 12b mit Serverschränken 10, wobei in der gezeigten Ausführungsform über die Länge des Zuluftkanals 22 mehrere Einströmöffnungen 48a, 48b, 48c, 48d, 48e ausgebildet sind. Über die Einströmöffnungen 48a, 48b, 48c, 48d, 48e kann Luft aus dem Zuluftkanal 22 deckenseitig nach unten in den Kaltgang 20 einströmen.

In den Kaltgang 20 einströmende Luft wird gemäß den in den Figuren 1 und 2 dargestellten Pfeilen K durch die Serverschränke 10 hindurch in den Warmgang 14 befördert. Dabei strömt die Luft in dem Ausführungsbeispiel von der Vorderseite der Serverschränke 10 zur Rückseite der Serverschränke 10. Die Luft verteilt sich über die Höhe der Serverschränke 10, was in Figur 2 durch die Vielzahl der über die Höhe des einen in Figur 2 erkennbaren Serverschranks 10 verteilten Pfeile K exemplarisch dargestellt ist.

Die in den Warmgang 14 einströmende Luft steigt anschließend nach oben und strömt durch - nur in den Figuren 3-5 dargestellte - Abluftöffnungen 50a, 50b, 50c, 50d, 50e, die analog zu den Einströmöffnungen 48a, 48b, 48c, 48d, 48e entlang des Abluftkanals 18 angeordnet sind, in den Abluftkanal 18 ein.

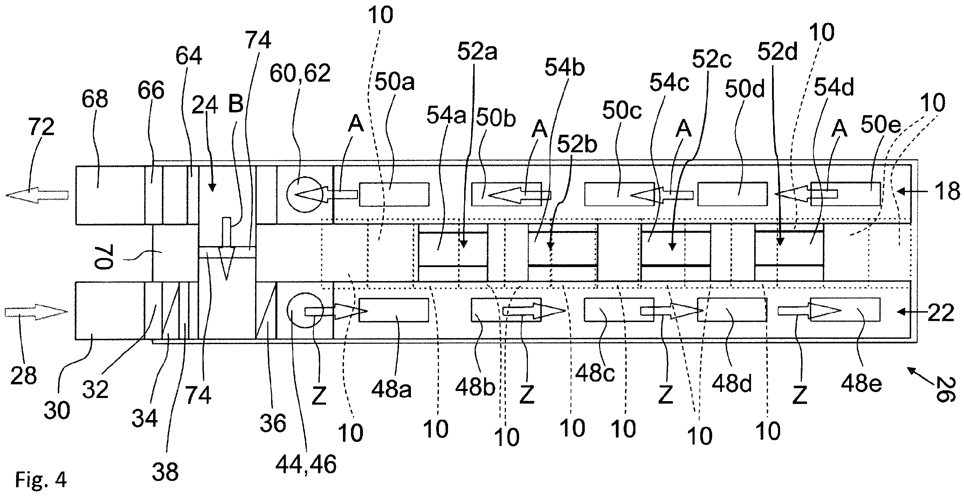

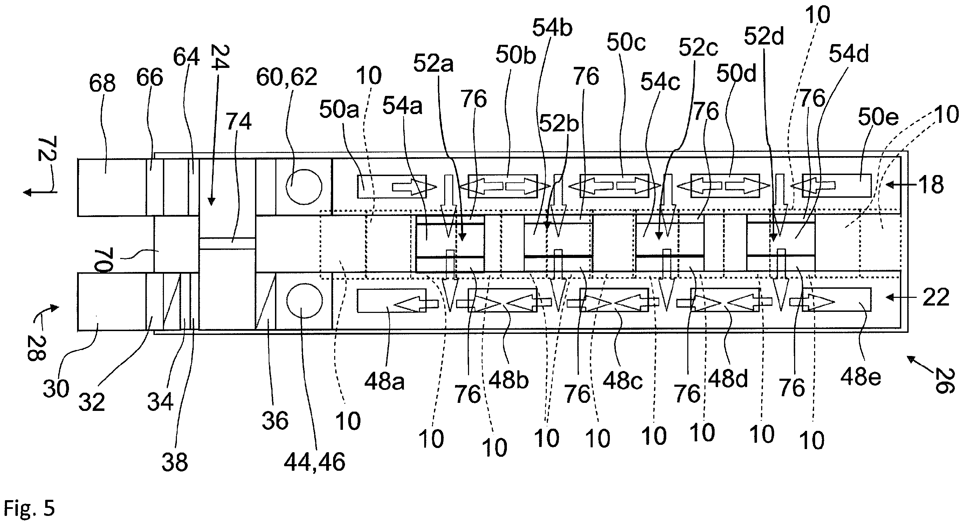

Der weitere Strömungsverlauf der durch die Abluftöffnungen 50a, 50b, 50c, 50d, 50e eingeströmten Luft hängt von der aktivierten Betriebsart der Anordnung ab. Dabei wird im Wesentlichen unterschieden zwischen einem Betrieb mit einer ausschließlichen direkten freien Kühlung gemäß Figur 4 und einem Umluftbetrieb, der in Figur 5 dargestellt ist. Darüber hinaus ist auch ein Mischbetrieb möglich.

Bevor im Folgenden die verschiedenen Betriebsarten erläutert werden, wird noch auf in Figur 3 dargestellte Verbindungskanäle 52a, 52b, 52c, 52d hingewiesen. Diese Verbindungskanäle 52a, 52b, 52c, 52d ermöglichen es, dass Luft von dem Abluftkanal 18 oberhalb der Serverschränke 10 zurück in den Zuluftkanal 22 strömen kann. In jedem der Verbindungskanäle 52a, 52b, 52c, 52d ist jeweils eine Kühlvorrichtung 54a, 54b, 54c, 54d angeordnet. Bei diesen Kühlvorrichtungen 54a, 54b, 54c, 54d handelt es sich in dem gezeigten Ausführungsbeispiel um sogenannte Split-Kühlvorrichtungen, die einen nicht im Detail dargestellten Verdampfer umfassen. Über nur schematisch dargestellte Verbindungsleitungen 56a, 56b, 56c, 56d ist der Verdampfer der jeweiligen Kühlvorrichtung 54a, 54b, 54c, 54d mit einem korrespondierenden Außengerät 58a, 58b, 58c, 58d mit Kompressor verbunden. Durch die Verbindungsleitungen 56a, 56b, 56c, 56d zirkulierendes Kältemittel wird dabei von dem jeweiligen Außengerät 58a, 58b, 58c, 58d mit dem jeweiligen Kompressor komprimiert und im korrespondierenden Verdampfer der Kühlvorrichtung 54a, 54b, 54c, 54d wieder verdampft. Beim Verdampfen wir der von dem Abluftkanal 18 zu dem Zuluftkanal 22 zuströmenden Luft auf bekannte Art und Weise Wärme entzogen, um die Luft abzukühlen.

Der Vollständigkeit halber wird darauf hingewiesen, dass anstelle der beschriebenen Split-Kühlvorrichtungen auch andere geeignete Kühlvorrichtungen verwendet werden können, beispielsweise Luft-Wasser-Wärmetauscher (nicht dargestellt) oder Kompakt-Kühlvorrichtungen (nicht dargestellt) mit Verdichter und Kompressor in einem Gerät.

In Figur 3 ist ferner zu erkennen, dass analog zu dem Zuluftventilator 46 als Luftfördermittel 60 für den Abluftkanal 18 ein Abluftventilator 62 vorgesehen ist.

Der Vollständigkeit halber wird darauf verwiesen, dass Luftfördermittel 44, 60, insbesondere Zu- und Abluftventilatoren 46, 62, und optionale weitere Luftfördermittel auch an anderen Stellen angeordnet werden können, z.B. unmittelbar vor oder hinter den Mischklappen 38, 64, 74.

Stromabwärts des Abluftventilators 62 schließt sich eine Abluft-Mischklappe 64 und eine Abluft-Brandschutzklappe 66 an. Stromabwärts der Abluft-Brandschutzklappe 66 ist wiederum ein optionaler Abluft-Schalldämpfer 68 angeordnet.

In Figur 3 ist ferner erkennbar, dass die Zuluft-Brandschutzklappe 32 und die Abluft-Brandschutzklappe 66 über ein Kopplungsmittel 70 miteinander verbunden sind. Die Brandschutzklappen 32, 66 können daher mittels des Kopplungsmittels 70 gemeinsam betätigt werden, um die Verbindung des Zuluftkanals 22 und des Abluftkanals 18 zu der Zuluftleitung 28 und einer in die Atmosphäre zurückführenden Abluftleitung 72 zu trennen.

In Figur 4 ist als eine erste Betriebsart ein Betrieb der erfindungsgemäßen Anordnung 26 mit direkter freier Kühlung gezeigt. In dieser Betriebsart mit direkter freier Kühlung ist die Zuluftleitung 28 geöffnet, so dass atmosphärische Außenluft, insbesondere aus der Umgebung des nicht dargestellten Gebäudes, in welchem sich die erfindungsgemäße Anordnung 26 befindet, über die Zuluftleitung 28 in den Zuluftkanal 22 gefördert werden kann.

Die Luft strömt dann entlang der Pfeile Z durch den Zuluftkanal 22 und gelangt durch die Austrittsöffnungen 48a, 48b, 48c, 48d in den Kaltgang 20. Vom Kaltgang 20 strömt die Luft durch die Serverschränke 10 in den Warmgang 14 und von dort aus durch die Abluftöffnungen 50a, 50b, 50c, 50d in den Abluftkanal 18. In dem Abluftkanal 18 strömt die Luft anschließend gemäß den Pfeilen A in Richtung des Bypasskanals 24.

Mittels der Abluft-Mischklappe 64 und einer im Bypasskanal 24 angeordneten Bypasskanal-Mischklappe 74 kann gesteuert werden, ob und welchem Menge an Abluft aus dem Abluftkanal 18 durch den Bypasskanal 24 in Richtung des Pfeils B zurück in den Zuluftkanal 22 strömen soll. Auf diese Art und Weise kann über die Zuluftleitung 28 zuströmende, möglicherweise zu kalte Luft, mit Hilfe der Beimengung von Abluft erwärmt werden, um eine Kondensatbildung oder eine sonstige Beeinträchtigung von in den Serverschränken 10 angeordneten Komponenten zu vermeiden. Überschüssige Abluft wird über die Abluftleitung 72 in die Atmosphäre gefördert, wozu die Abluft-Mischklappe 64 zumindest teilweise geöffnet sein muss.

Figur 5 zeigt eine zweite Betriebsart einer erfindungsgemäßen Anordnung 26. Bei dieser Betriebsart sind die Kühlvorrichtungen 54a, 54b, 54c, 54d alle aktiviert. In diesem Fall wird Luft auch direkt über die Verbindungskanäle 52a, 52b, 52c, 52d von dem Abluftkanal 18 in den Zuluftkanal 22 gefördert. Dabei wird die Luft mit Hilfe der Kühlvorrichtungen 54a, 54b, 54c, 54d abgekühlt.

Um eine Rückströmung von gekühlter Luft aus dem Zuluftkanal 22 in den Abluftkanal 18 zu verhindern, sind in den Verbindungskanälen 52a, 52b, 52c, 52d vor und/oder hinter den Kühlvorrichtungen 54a, 54b, 54c, 54d Rückschlagklappen 76 angeordnet. Diese Rückschlagklappen 76 sind so ausgebildet und angeordnet, dass bei einer ausreichend starken Luftströmung von dem Abluftkanal 18 in den Zuluftkanal 22 sich die entsprechende Klappe 76 in Richtung des Zuluftkanals 22 öffnet. In umgekehrter Richtung schlägt die nicht dargestellte Klappe an einem nicht dargestellten Anschlag an und vermeidet so eine Rückströmung von kalter Luft in Richtung Abluftkanal 18.
In der in Figur 5 dargestellten Betriebsart ist die Bypass-Mischklappe 74 geschlossen, um keine ungekühlte Abluft in den Zuluftkanal 22 zu fördern. Wenn die mit den Kühlvorrichtungen 54a-d erzeugte, abgekühlte Luft allerdings zu kalt ist, kann ein Teil der Abluft über den Bypasskanal 24 zurück in den Zuluftkanal 22 gefördert werden, um die vom Zuluftkanal 22 in den Kaltgang 20 einströmende Luft zu erwärmen.

In der in Figur 5 gezeigten Betriebsart ist es auch möglich, die Brandschutzklappen 32, 66 und/oder die Zuluft-Mischklappe 38 und die Abluft-Mischklappe 64 zu schließen, so dass ein reiner Umluftbetrieb stattfindet. Dies kann insbesondere dann von Vorteil sein, wenn in dem Gebäude, in welchem sich die erfindungsgemäße Anordnung 26 befindet, ein Feuer detektiert wird und/oder wenn andere Schadstoffe detektiert werden, die nicht in den Raum, in welchem sich die Serverschränke 10 befinden, hineingefördert werden sollen.

Der Vollständigkeit halber wird noch einmal darauf verwiesen, dass die erfindungsgemäße Anordnung 26 auch in einem Mischbetrieb betrieben werden kann, d.h. es ist bedarfsweise auch möglich, gleichzeitig eine direkte freie Kühlung und eine mechanische Kühlung mittels Kühlvorrichtungen 54a, 54b, 54c, 54d durchzuführen, beispielsweise um eine gewünschte Temperatur und/oder eine gewünschte Luftfeuchtigkeit zu erzielen.

Wie bereits erwähnt, sind in der in den Figuren 3-5 dargestellten Anordnung der Zuluftkanal 22, der Abluftkanal 18 und die Verbindungskanäle 52a-d leiterartig angeordnet, wobei sich der Zuluftkanal 22 und der Abluftkanal 18 in Längsrichtung erstrecken und die Verbindungskanäle 52a-d sprossenartig in Querrichtung erstrecken. Diese Anordnung mit der leiterartigen Ausbildung und mehreren (hier: 4) Verbindungskanälen 52a-d hat den Vorteil, dass entlang der Länge des Ablaufkanals 18 und der Zuluftkanals 22 auch partiell ein Umluftbetrieb möglich ist, beispielsweise wenn in dem Bereich der Serverschränke 10 unterhalb der Kühlvorrichtungen 54a, 54b Wartungsarbeiten durchgeführt und die Server entsprechend abgeschaltet werden. In diesem Fall können - und auch dies nur bedarfsweise - nur die Kühlvorrichtungen 54c, 54d betrieben werden.

Der Vollständigkeit halber wird darauf verwiesen, dass die Möglichkeit der Aktivierung der Kühlvorrichtungen 54a-d daran gekoppelt sein kann, dass ein entsprechendes Signal von mindestens einem darunter angeordneten Serverschrank vorhanden ist, beispielsweise ein Signal einer geschlossenen Serverschranktür auf der Vorderseite und/oder auf der Rückseite und/oder ein Signal eines laufenden Servers in einem Serverschrank. So können Wartungsarbeiten an einzelnen Serverschränken automatisch detektiert und für eine bedarfsgerechte Kühlung der jeweiligen Abschnitt einer Reihe 12a, 12b, 12c genutzt werden.

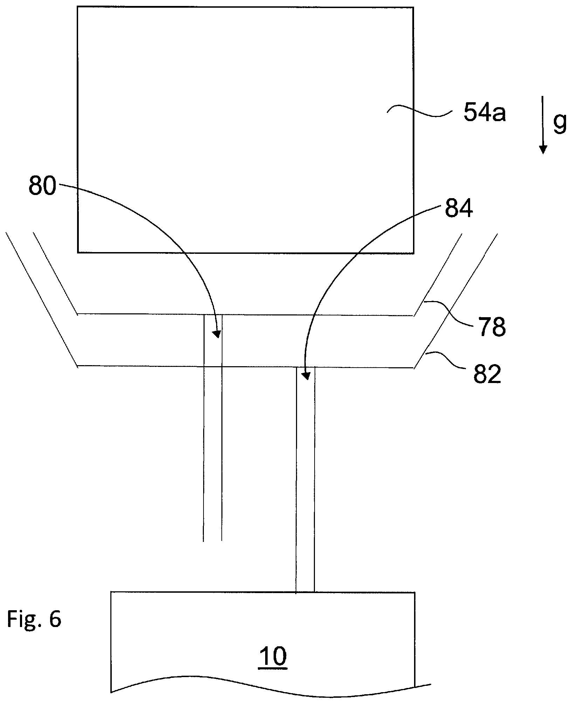

Exemplarisch nur an der Kühlvorrichtung 54a dargestellt ist in Figur 6 eine Anordnung einer ersten Kondensatwanne 78 und einer zweiten Kondensatwanne 82, mittels welchen vermieden wird, dass aus der Kühlvorrichtung 54a austretendes oder an dieser entstehendes Kondensat nach unten in Richtung der Schwerkraft g auf die Serverschränke 10 tropfen kann. Dazu ist die erste Kondensatwanne 78 mit einem ersten Ablaufkanal 80 unterhalb der Kühlvorrichtung 54a angeordnet. Die erste Kondensatwanne 78 erstreckt sich über eine Länge und eine Breite, die jeweils größer ist als die Länge und Breite der darüber angeordneten Kühlvorrichtung 54a.

Für den Fall, dass es zu einer Verstopfung des ersten Ablaufkanals 80 oder zu sonstigen technischen Problemen mit der ersten Kondensatwanne 78 kommt, ist unterhalb der ersten Kondensatwanne 78 die zweite Kondensatwanne 82 mit einem zweiten Ablaufkanal 84 angeordnet. Die zweite Kondensatwanne 82 weist eine noch größere Länge und eine noch größere Breite als die erste Kondensatwanne 78 auf, so dass aus der ersten Kondensatwanne 78 austretendes Kondensat zwangsläufig von der zweiten Kondensatwanne 82 aufgefangen wird.

Der erste Ablaufkanal 80 und der zweite Ablaufkanal 84 sind unabhängig voneinander und ermöglichen daher ein sicheres Abströmen von Kondensat, auch wenn einer der Ablaufkanäle 80, 84 gestört sein sollte.

Die in der vorliegenden Beschreibung, in den Zeichnungen sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein. Die Erfindung ist nicht auf die beschriebenen Ausführungsformen beschränkt. Sie kann im Rahmen der Ansprüche und unter Berücksichtigung der Kenntnisse des zuständigen Fachmanns variiert werden. Insbesondere wird in diesem Zusammenhang darauf verwiesen, dass jedes einzelne Merkmal, das in der Figurenbeschreibung erwähnt, aber nicht Gegenstand des Anspruchs 1 ist, einzeln mit dem Gegenstand des Anspruch 1 kombiniert werden kann, auch dann wenn das Merkmal gemeinsam mit anderen Merkmalen beschrieben ist. Dies gilt vorliegend insbesondere für Elemente wie Grob- und Feinfilter, Schalldämpfer, Brandschutzklappen, Mischklappen und Steuerungen.

### Bezugszeichenliste

- 10: Serverschrank
- 12a,b,c: Reihe
- 14: Warmgang
- 16: Boden
- 18: Abluftkanal
- 20: Kaltgang
- 22: Zuluftkanal
- 24: Bypasskanal
- 26: erfindungsgemäße Anordnung
- 28: Zuluftleitung
- 30: Abström-Schalldämpfer
- 32: Zuluft-Brandschutzklappe
- 34: Grobfilter
- 36: Feinfilter
- 38: Zuluft-Mischklappe
- 44: Luftfördermittel (Zuluftkanal)
- 46: Zuluftventilator
- 48a-e: Einströmöffnung
- 50a-e: Abluftöffnung
- 52a-d: Verbindungskanal
- 54a-d: Kühlvorrichtung
- 56a-d: Verbindungsleitung
- 58a-d: Außengerät (Kompressor)
- 60: Luftfördermittel (Abluftkanal)
- 62: Abluftventilator
- 64: Abluft-Mischklappe
- 66: Abluft-Brandschutzklappe
- 68: Abluft-Schalldämpfer
- 70: Kopplungsmittel
- 72: Abluftleitung
- 74: Bypasskanal-Mischklappe
- 76: Rückschlagklappe
- 78: erste Kondensatwanne
- 80: erster Ablaufkanal
- 82: zweite Kondensatwanne
- 84: zweiter Ablaufkanal

## Patentansprüche

1. Anordnung eines Kühlsystems zur Kühlung mindestens eines, in einem Raum angeordneten Serverschranks (10), wobei zumindest ein auf einer ersten Seite des Serverschranks (10) angeordneter Kaltgang (20) vorgesehen ist und wobei ein, auf einer zweiten Seite des Serverschranks (10) angeordneter Warmgang (14) vorgesehen ist, wobei zur Kühlung des mindestens einen Serverschranks (10) deckenseitig des Raums mindestens ein, den Kaltgang (20) mit Kühlluft versorgender Zuluftkanal (22) mit mindestens einer von dem Zuluftkanal (22) in den Kaltgang (20) führenden Einströmöffnung (48a, 48b, 48c, 48d, 48e) vorgesehen ist und wobei im Warmgang (14) deckenseitig des Raums ein Luft aus dem Warmgang (14) fördernder Abluftkanal (18) mit mindestens einer von dem Warmgang (14) in den Abluftkanal (18) führenden Abluftöffnung (50a, 50b, 50c, 50d) vorgesehen ist, wobei in dem Zuluftkanal (22), in dem Abluftkanal (18) oder in mindestens einem von dem Abluftkanal (18) zum Zuluftkanal (22) führenden Verbindungskanal (52a, 52b, 52c, 52d) mindestens eine Kühlvorrichtung (54a, 54b, 54c, 54d) angeordnet ist,
wobei der Zuluftkanal (22) mit einer Zuluftleitung (28) für eine direkte freie Kühlung verbunden ist und mehrere Serverschränke (10) in einer Reihe (12a, 12b, 12c) angeordnet sind und mehrere Kühlvorrichtungen (54a, 54b, 54c, 54d) in mehreren, jeweils von dem Abluftkanal (18) zu dem Zuluftkanal (22) führenden Verbindungskanälen (52a, 52b, 52c, 52d) angeordnet sind, wobei die Kühlvorrichtungen (54a, 54b, 54c, 54d) ebenfalls in einer Reihe (12a) unmittelbar über den Serverschränken (10) angeordnet sind.

2. Anordnung nach dem vorstehenden Anspruch, **dadurch gekennzeichnet, dass** für die direkte freie Kühlung mindestens eine Zuluftleitung (28) und mindestens eine Abluftleitung (72) vorgesehen ist, wobei in der Zuluftleitung (28) eine Zuluft-Brandschutzklappe (32) und in der Abluftleitung (72) eine Abluft-Brandschutzklappe (66) vorgesehen ist, um die Zuluftleitung (28) und die Abluftleitung (72) bedarfsweise vollständig verschließen zu können.

3. Anordnung nach einem der vorstehenden Ansprüche, **dadurch gekennzeichnet, dass**
a) in dem Zuluftkanal (22) mehrere Einströmöffnungen (48a, 48b, 48c, 48d, 48e) angeordnet sind und mindestens eine Einströmöffnung (48) eine Luftmengensteuervorrichtung aufweist, und/oder
b) in dem Abluftkanal (18) mehrere Abluftöffnungen (50a, 50b, 50c, 50d, 50e) angeordnet sind und mindestens eine Abluftöffnung (50a, 50b, 50c, 50d, 50e) eine Luftmengensteuervorrichtung aufweist.

4. Anordnung nach einem der vorstehenden Ansprüche, **dadurch gekennzeichnet, dass** der Abluftkanal (18) über einen Bypasskanal (24) mit dem Zuluftkanal (22) verbunden ist und mindestens eine Mischkammer vorgesehen ist, um einen Frischluftstrom und einen Abluftstrom für die Einströmung in den Zuluftkanal (22) zusammenzuführen und konditionieren zu können.

5. Anordnung nach einem der vorstehenden Ansprüche, **dadurch gekennzeichnet, dass** mindestens eine Rückschlagarmatur derart in dem Abluftkanal (18), in dem Verbindungskanal (52), in dem Bypasskanal (24) und/oder in dem Zuluftkanal (22) angeordnet ist, dass einer Luftströmung von dem Zuluftkanal (22) durch den Verbindungskanal (52) oder den Bypasskanal (24) in den Abluftkanal (18) mittels der Rückschlagarmatur entgegengewirkt wird.

6. Anordnung nach einem der vorstehenden Ansprüche, **dadurch gekennzeichnet, dass** mindestens eine Steuervorrichtung vorgesehen ist, um den Durchströmquerschnitt mindestens einer Auslassöffnung und/oder die Steuerung von Mischklappen einer Mischkammer abhängig von mit Hilfe von Sensoren ermittelten Steuerparametern und/oder Regelparametern einzustellen.

7. Anordnung nach einem der vorstehenden Ansprüche, **dadurch gekennzeichnet, dass** mindestens eine erste Überwachungsvorrichtung für die direkte freie Kühlung und eine zweite Überwachungsvorrichtung für die Kühlvorrichtung vorgesehen sind, mittels welchen unabhängig voneinander die Temperatur im Zuluftkanal (22) überwacht wird.

8. Anordnung nach einem der vorstehenden Ansprüche, **dadurch gekennzeichnet, dass** eine Master-Überwachungsvorrichtung mit einem Bimetall-Schalter vorgesehen ist, die funktional derart mit der mindestens einen Kühlvorrichtung (54a, 54b, 54c, 54d) gekoppelt ist, dass bei Erreichen oder Überschreiten einer Maximaltemperatur die mindestens eine Kühlvorrichtung (54a, 54b, 54c, 54d) aktiviert wird.

9. Anordnung nach einem der vorstehenden Ansprüche, **dadurch gekennzeichnet, dass** die mindestens eine Kühlvorrichtung (54a, 54b, 54c, 54d) von einer ersten Kondensatwanne (78) und von einer zweiten Kondensatwanne (82) derart umgeben sind, dass Kondensat zunächst von der ersten Kondensatwanne (78) aufgefangen und in einen ersten Ablaufkanal (80) geführt wird und im Falle einer Fehlfunktion Kondensat von der ersten Kondensatwanne (78) in die zweite Kondensatwanne (82) überläuft und von dieser in einen zweiten Ablaufkanal (84) geführt wird.

## Claims

1. An assembly of a cooling system for cooling at least one server rack (10) arranged in a room, wherein at least one cold aisle (20) arranged on a first side of the server rack (10) is provided and wherein one hot aisle (14) arranged on a second side of the server rack (10) is provided, wherein at least one supply air duct (22) supplying cooling air to the cold aisle (20) and having at least one inflow opening (48a, 48b, 48c, 48d, 48e) leading from the supply air duct (22) to the cold aisle (20) is provided on the ceiling side of the room for cooling the at least one server rack (10) and wherein an exhaust air duct (18) conveying air from the hot aisle (14) and having at least one exhaust air opening (50a, 50b, 50c, 50d) leading from the hot aisle (14) to the exhaust air duct (18) is provided in the hot aisle (14) on the ceiling side of the room, wherein at least one cooling device (54a, 54b, 54c, 54d) is arranged in the supply air duct (22), in the exhaust air duct (18) or in at least one connecting duct (52a, 52b, 52c, 52d) leading from the exhaust air duct (18) to the supply air duct (22),
wherein
the supply air duct (22) is connected to a supply air line (28) for a direct free cooling and several server racks (10) are arranged in a row (12a, 12b, 12c) and several cooling devices (54a, 54b, 54c, 54d) are arranged in several connecting ducts (52a, 52b, 52c, 52d), each leading from the exhaust air duct (18) to the supply air duct (22), wherein the cooling devices (54a, 54b, 54c, 54d) are also arranged in a row (12a) directly above the server racks (10).

2. The assembly according to the preceding claim, **characterised in that** at least one supply air line (28) and at least one exhaust air line (72) are provided for the direct free cooling, wherein a supply air fire protection flap (32) is provided in the supply air line (28) and an exhaust air fire protection flap (32) is provided in the exhaust air line (72) to be able to completely close the supply air line (28) and the exhaust air line (72) as required.

3. The assembly according to any one of the preceding claims, **characterised in that**
a) several inflow openings (48a, 48b, 48c, 48d, 48e) are arranged in the supply air duct (22) and at least one inflow opening (48) has an air volume control device and/or
b) several exhaust air openings (50a, 50b, 50c, 50d, 50e) are arranged in the exhaust air duct (18) and at least one exhaust air duct (50a, 50b, 50c, 50d, 50e) comprises an air volume control device.

4. The assembly according to any one of the preceding claims, **characterised in that** a bypass duct (24) connects the exhaust air duct (18) to the supply air duct (22) and at least one mixing chamber is provided to be able to merge and condition a fresh air flow and an exhaust air flow for flowing into in the supply air duct (22).

5. The assembly according to any one of the preceding claims, **characterised in that** at least one check valve is arranged in the exhaust air duct (18), in the connecting duct (52), in the bypass duct (24) and/or in the supply air duct (22) to counteract an air flow from the supply air duct (22) through the connecting duct (52) or the bypass duct (24) into the exhaust air duct (18) by means of the check valve (76).

6. The assembly according to any one of the preceding claims, **characterised in that** at least one control device is provided to adjust the throughflow cross-section of at least one outlet opening and/or the control of mixing flaps of a mixing chamber depending on control parameters and/or closed-loop control parameters determined by sensors.

7. The assembly according to any one of the preceding claims, **characterised in that** at least one first monitoring device for the direct free cooling and a second monitoring device for the cooling device are provided to monitor the temperature in the supply air duct (22) independently of one another.

8. The assembly according to any one of the preceding claims, **characterised in that** a master monitoring device having a bimetal switch is provided that is operably coupled with the at least one cooling device (54a, 54b, 54c, 54d) such that the at least one cooling device (54a, 54b, 54c, 54d) is activated when a maximum temperature is reached or exceeded.

9. The assembly according to any one of the preceding claims, **characterised in that** the at least one cooling device (54a, 54b, 54c, 54d) is surrounded by a first condensate tray (78) and a second condensate tray (82) such that condensate is first collected by the first condensate tray (78) and introduced into a first drain duct (80) and in case of a malfunction condensate overflows from the first condensate tray (78) into the second condensate tray (82) and is introduced therefrom into a second drain duct (84).

## Revendications

1. Agencement d'un système de refroidissement destiné au refroidissement d'au moins une armoire de serveur (10) agencée dans une pièce, dans lequel au moins une allée froide (20) agencée sur un premier côté de l'armoire de serveur (10) est prévue, et une allée chaude (14) agencée sur un second côté de l'armoire de serveur (10) est prévue, dans lequel pour refroidir la au moins une armoire de serveur (10), au moins un canal d'entrée d'air (22) alimentant l'allée froide (20) en air de refroidissement est prévu côté plafond de la pièce, avec au moins une ouverture d'admission (48a, 48b, 48c, 48d, 48e) menant du canal d'entrée d'air (22) jusque dans l'allée froide (20), et dans lequel dans l'allée chaude (14), un canal de sortie d'air (18) transportant de l'air depuis l'allée chaude (14) est prévu côté plafond de la pièce, avec au moins une ouverture de sortie d'air (50a, 50b, 50c, 50d) menant de l'allée chaude (14) jusque dans le canal de sortie d'air (18), dans lequel dans le canal d'entrée d'air (22), dans le canal de sortie d'air (18), ou dans au moins un canal de connexion (52a, 52b, 52c, 52d) menant du canal de sortie d'air (18) au canal d'entrée d'air (22) est agencé au moins un dispositif de refroidissement (54a, 54b, 54c, 54d),
dans lequel
le canal d'entrée d'air (22) est connecté à une conduite d'entrée d'air (28) pour un refroidissement libre direct, et plusieurs armoires de serveur (10) sont agencées en une rangée (12a, 12b, 12c), et plusieurs dispositifs de refroidissement (54a, 54b, 54c, 54d) sont agencés dans plusieurs canaux de connexion (52a, 52b, 52c, 52d) menant chacun du canal de sortie d'air (18) au canal d'entrée d'air (22), dans lequel les dispositifs de refroidissement (54a, 54b, 54c, 54d) sont également agencés en une rangée (12a) directement au-dessus des armoires de serveur (10).

2. Agencement selon la revendication précédente, **caractérisé en ce qu'**au moins une conduite d'entrée d'air (28) et au moins une conduite de sortie d'air (72) sont prévues pour le refroidissement libre direct, dans lequel un clapet coupe-feu d'entrée d'air (32) est prévu dans la conduite d'entrée d'air (28) et un clapet coupe-feu de sortie d'air (66) est prévu dans la conduite de sortie d'air (72), afin de pouvoir fermer complètement la conduite d'entrée d'air (28) et la conduite de sortie d'air (72) selon les besoins.

3. Agencement selon l'une des revendications précédentes, **caractérisé en ce que**
a) une pluralité d'ouvertures d'entrée (48a, 48b, 48c, 48d, 48e) sont agencées dans le canal d'entrée d'air (22) et au moins une ouverture d'entrée (48) présente un dispositif de commande de quantité d'air, et/ou
b) une pluralité d'ouvertures de sortie d'air (50a, 50b, 50c, 50d, 50e) sont agencées dans le canal de sortie d'air (18) et au moins une ouverture de sortie d'air (50a, 50b, 50c, 50d, 50e) présente un dispositif de commande de quantité d'air.

4. Agencement selon l'une des revendications précédentes, **caractérisé en ce que** le canal de sortie d'air (18) est connecté au canal d'entrée d'air (22) via un canal de dérivation (24) et au moins une chambre de mélange est prévue, pour pouvoir réunir et conditionner un flux d'air frais et un flux d'air d'échappement pour l'entrée dans le canal d'entrée d'air (22).

5. Agencement selon l'une des revendications précédentes, **caractérisé en ce qu'**au moins un volet anti-retour est agencé dans le canal de sortie d'air (18), dans le canal de connexion (52), dans le canal de dérivation (24) et/ou dans le canal d'entrée d'air (22), de sorte qu'un flux d'air à partir du canal d'entrée d'air (22), à travers le canal de connexion (52) ou le canal de dérivation (24) jusque dans le canal de sortie d'air (18), est contrecarré au moyen du volet anti-retour (76).

6. Agencement selon l'une des revendications précédentes, **caractérisé en ce qu'**au moins un dispositif de commande est prévu pour régler la section transversale d'écoulement d'au moins une ouverture de sortie et/ou la commande de volets de mélange d'une chambre de mélange en fonction de paramètres de commande et/ou de paramètres de régulation déterminés à l'aide de capteurs.

7. Agencement selon l'une des revendications précédentes, **caractérisé en ce qu'**au moins un premier dispositif de surveillance pour le refroidissement libre direct et un second dispositif de surveillance pour le dispositif de refroidissement sont prévus, au moyen desquels la température dans le canal d'entrée d'air (22) est surveillée indépendamment l'un de l'autre.

8. Agencement selon l'une des revendications précédentes, **caractérisé en ce qu'**un dispositif de surveillance principal pourvu d'un commutateur bimétallique est prévu, qui est couplé fonctionnellement au au moins un dispositif de refroidissement (54a, 54b, 54c, 54d) de telle sorte que lorsqu'une température maximale est atteinte ou dépassée, le au moins un dispositif de refroidissement (54a, 54b, 54c, 54d) est activé.

9. Agencement selon l'une des revendications précédentes, **caractérisé en ce que** le au moins un dispositif de refroidissement (54a, 54b, 54c, 54d) est entouré par un premier bac à condensats (78) et par un second bac à condensats (82) de sorte qu'un condensat est d'abord collecté à partir du premier bac à condensats (78) puis mené dans un premier canal d'évacuation (80) et, en cas de dysfonctionnement, le condensat déborde du premier bac à condensats (78) dans le second bac à condensats (82), et est mené de celui-ci jusque dans un second canal d'évacuation (84).
